# EUROPÄISCHE PATENTSCHRIFT

(11) **EP 1 144 719 B1**
(45) Veröffentlichungstag und Bekanntmachung des Hinweises auf die Patenterteilung: **30.07.2003**
(21) Anmeldenummer: 99968768.4
(22) Anmeldetag: 29.10.1999
(51) Int. Cl.: C23C 16/26, C23C 28/00

(54) **POLYKRISTALLINE DIAMANTSCHICHT MIT (100)-TEXTUR**
POLYCRYSTALLINE DIAMOND LAYER WITH OPTIMIZED SURFACE PROPERTIES
COUCHE DE DIAMANT POLYCRISTALLINE A CARACTERISTIQUES DE SURFACE OPTIMISEES

(30) Priorität: 02.11.1998 DE 19850346
(43) Veröffentlichungstag der Anmeldung: 17.10.2001
(73) Patentinhaber: Fraunhofer-Gesellschaft zur Förderung der angewandten Forschung e.V., 80636 München (DE)
(72) Erfinder: FRYDA, Matthias, D-38110 Braunschweig (DE); BRAND, Jochen, D-38100 Braunschweig (DE)
(74) Vertreter: Einsel, Martin
(86) Internationale Anmeldenummer: EP9908221
(87) Internationale Veröffentlichungsnummer: WO00026433

(56) Entgegenhaltungen:
- EP-A- 0 807 693
- DE-A- 19 511 829
- US-A- 4 992 082
- US-A- 5 108 813
- US-A- 5 437 891
- WILD C ET AL: "CHEMICAL VAPOUR DEPOSITION AND CHARACTERIZATION OF SMOOTH {100}-FACETED DIAMOND FILMS" DIAMOND AND RELATED MATERIALS,NL,ELSEVIER SCIENCE PUBLISHERS, AMSTERDAM, Bd. 2, Nr. 2 / 04, 31. März 1993 (1993-03-31), Seiten 158-168, XP000361165 ISSN: 0925-9635 in der Anmeldung erwähnt

## Beschreibung

Die Erfindung betrifft polykristalline Diamantschichten, die neben Abriebsfestigkeit und geringem Verschleiß weitere Eigenschaften aufweisen können und somit gezielt für den jeweiligen Anwendungszweck optimiert werden können.

Es ist bekannt, Komponenten, die tribologischen Beanspruchungen unterliegen, wie zum Beispiel Werkzeuge für spanende Materialbearbeitung, mit harten, reibungs- und verschleißresistenten Beschichtungen zu versehen.
Insbesondere Beschichtungen aus polykristallinen Diamant ermöglichen aufgrund ihrer hervorragenden Verschleißfestigkeit und sehr guten Reibeigenschaften eine deutliche Standzeitverlängerung derartiger Komponenten selbst unter extrem abrasiven Bedingungen

Die Herstellung von polykristallinen Diamantschichten mittels diverser Abscheidungsverfahren aus der Gasphase wie CVD, zum Beispiel hot filament chemical vapor deposition (HF-CVD) oder micro wave chemical vapor deposition, oder plasma jet, ist allgemein bekannt und in der Literatur vielfach beschrieben, z. B. in K. Bachmann, W. van Enckevort, "Diamond deposition technologies" in Diamond and Related Materials, 1 (1992), Seiten 1021 bis 1034 oder B. Lux et. al., "Diamond for toolings and abrasives" in derselben Publikation auf Seiten 1034 bis 1047.

Weiter wird in C. Wild et al. "Chemical vapour deposition and characterization of smooth [100]-faceted diamond films" in :diamond and related materials 2 (1993), Seiten 158 bis 168, in EP 0 807 693 sowie dem US-Patent 5,437,891 die Herstellung von <100>- orientierten Diamantschichten mit glatter Oberfläche beschrieben.

US-Patent 4,992,082 betrifft ein Werkzeug mit einer Diamantschicht, wobei die Diamantschicht erzeugt wird, indem auf der betreffenden Werkzeugoberfläche eine Vielzahl einzelner miteinander nicht in Berührung stehender Diamantpartikel aufwachsen gelassen wird, deren Orientierung statistisch ist, und diese Diamantpartikel in eine Matrix aus einem Bindemittel eingebettet werden zur Erhöhung der Haftfestigkeit.

Es hat sich jedoch gezeigt, dass für viele Anwendungen neben einer hohen Verschleißbeständigkeit weitere Eigenschaften gefordert sind, um ein optimales Ergebnis erzielen zu können.

So kann es je nach Anwendungszweck wünschenswert sein, die Komponente mit weiteren Eigenschaften auszustatten, zum Beispiel um das Benetzungsverhalten oder die Gleiteigenschaften der Oberflächen zu variieren oder es können gute Antihafteigenschaften gefordert sein, um ein Verkleben von zu verarbeitendem Material an den Oberflächen eines zerspanenden Werkzeuges zu verhindern oder um örtliche Verschweißungen zu vermeiden.

Es wurden zahlreiche Vorschläge gemacht, die Oberflächeneigenschaften von derartigen Werkzeugen zu variieren, indem mittels bekannter Abscheidungsverfahren Schichten verschiedener Zusammensetzung und damit verschiedener Eigenschaften auf das Werkzeug aufgetragen werden.

So ist bekannt, dass sich durch die Kombination von Hartstaffschichten mit reibarmen Deckschichten die Lebensdauer von tribologisch beanspruchten Werkzeugen, z. B. Bohrern, erhöhen lässt.

Die EP-A 0 625 588 beschreibt eine Plasmapolymer-Schichtenfolge als Hartstoffschicht auf Substraten mit einer Funktionsschicht, die neben den Basiselementen Kohlenstoff und Wasserstoff noch zusätzliche nichtmetallische beziehungsweise halbmetallische Elemente enthält, und die über herkömmliche PVD- oder CVD-Verfahren hergestellt werden kann. Die Funktionsschicht dient der Beeinflussung des Benetzungs- beziehungsweise Adhäsionsverhaltens gegenüber Flüssigkeiten und Gasen und soll der Oberfläche chemische Resistenz gegenüber Säuren, Laugen und Lösungsmittel verleihen.

So beschreibt das US-Patent 5,108,813 ein Gleitelement mit einer statistisch gewachsenen Diamantschicht, wobei in die Oberflächenunregelmäßigkeiten dieser statistisch gewachsenen Diamantschicht ein weiches Metall aufgebracht ist zur Verbesserung des Reibungskoeffizienten. Statistisch gewachsene Diamantschichten weisen eine ungleichförmige Oberflächenmorphologie auf mit Rauheiten unterschiedlichster Tiefe und Struktur.

Es besteht jedoch ein erheblicher Bedarf an einer gleichförmigen Diamantbeschichtung, der auf einfache Weise die unterschiedlichsten zusätzlichen Eigenschaften verliehen werden können.

Es ist daher Aufgabe der vorliegenden Erfindung, eine verbesserte Diamantbeschichtung zur Verfügung zu stellen, die neben Verschleiß- und Reibungsfestigkeit zusätzliche Funktionen aufweist und ein Verfahren zur Herstellung einer solchen Schicht.

Gelöst wird diese Aufgabe durch eine polykristalline Diamantschicht mit (100)-Textur und definiert eingestellter Oberflächenrauhigkeit mit den Merkmalen des Anspruches 1.

Die erfindungsgemäßen Diamantschichten weisen eine definiert eingestellte Rauhigkeit auf, wobei die Rauhigkeitstäler oder Vertiefungen mit wenigstens einem anderen Material aufgefüllt werden, das der Diamantschicht die zusätzlich gewünschte Eigenschaft verleiht.

Das wenigstens eine Material kann dabei alle oder nur einen Teil der Vertiefungen ganz oder teilweise ausfüllen, es kann über die Vertiefungen hinausreichen und die Oberfläche ganz oder teilweise bedecken.

Auch kann auf die Diamantschicht vor oder nach dem Aufbringen des gewünschten Materials eine oder mehrere Schichten aufgebracht werden.

Definiert eingestellte Rauhigkeit im Sinne der vorliegenden Erfindung bedeutet, dass die Rauhigkeitstäler im Vergleich zu statistisch-orientiert gewachsenen Diamantschichten eine in etwa gleichförmige Tiefe aufweisen, wobei verfahrensbedingte Schwankungen möglich sind. Die verfahrensbedingten Schwankungen sind jedoch gegenüber der Schwankungsbreite der bei statistisch-orientiert wachsenen Diamantschichten auftretenden Rauhigkeitstäler gering.

Die erfindungsgemäße Diamantschicht ist im wesentlichen orientiert gewachsen und weist (100)-Textur auf, wobei die (100)-Ebene der Diamantkristalle im wesentlichen horizontal zur Substratoberfläche ausgerichtet ist.

Die erfindungsgemäße Diamantschicht mit (100)-Textur und definiert eingestellter Oberflächenrauhigkeit kann über eine mehrstufige Gasphasenabscheidung (CVD) erhalten werden. Besonders bevorzugt ist hierbei die Verwendung des hot filament chemical vapor deposition (HF-CVD)-Verfahrens.

Hierbei erfolgt nach der üblichen Vorbekeimung eines beliebigen gewünschten Substrates in einer ersten Stufe die Abscheidung der texturierten Diamantschicht mit einer Vorzugsrichtung des Kristallwachstums im wesentlichen senkrecht zur Substratoberfläche zur Einstellung der maximalen Tiefe der Rauhigkeit und in einer zweiten Stufe mit einer Vorzugsrichtung des Kristallwachstums im wesentlichen horizontal zur Substratoberfläche die Einstellung des Oberflächenverhältnisses und damit des Flächenanteils der Öffnungsweite der Vertiefungen an der Gesamtoberfläche.

im folgenden wird die Erfindung anhand der Zeichnungen beispielhaft erläutert.

Es zeigen:
- **Figur 1:**: eine rasterelektronenmikroskopische Aufnahme einer statistisch orientiert gewachsenen Diamantschicht;
- **Figur 1b:**: schematisch den Kontakt eines Gegenkörpers mit einer statistisch orientierten Diamantschicht;
- **Figur 2a:**: eine rasterelektronenmikroskopische Aufnahme nach Abscheidung der texturierten Diamantschicht zur Einstellung der gewünschten Rauhigkeitstiefe (1. Stufe);
- **Figur 2b:**: eine schematische Darstellung der Schicht nach der ersten Stufe;
- **Figur 3a:**: eine rasterelektronenmikroskopische Aufnahme der erfindungsgemäßen Diamantschicht nach der zweiten Stufe;
- **Figur 3b:**: eine schematische Darstellung des Aufbaues der erfindungsgmäßen Schicht und
- **Figur 4:**: zwei Variationen der erfindungsgemäßen Schicht mit aufgetragenem Funktionsmaterial.

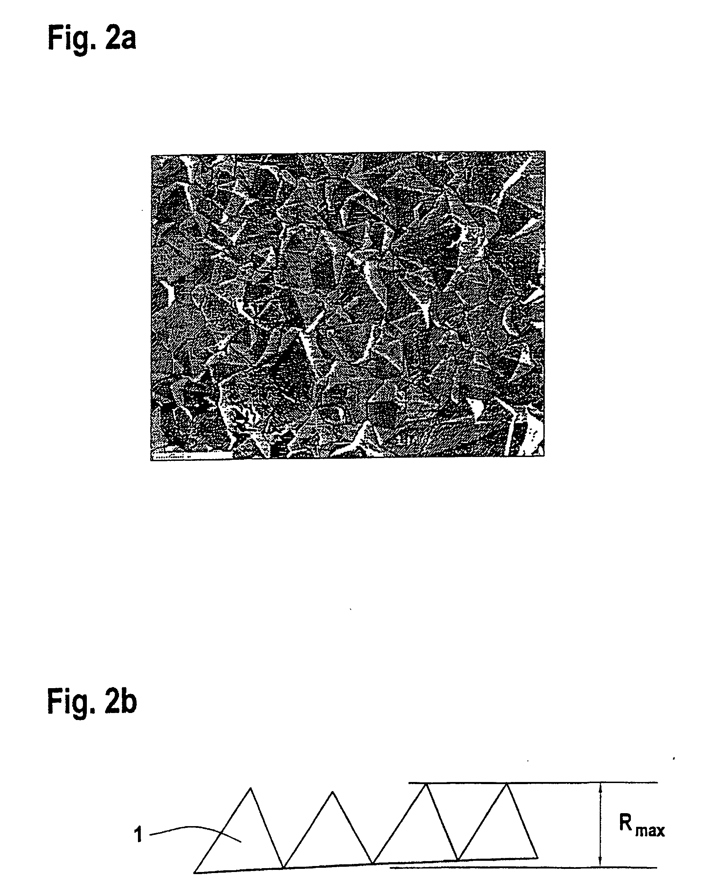

Wie in den **Figuren 2 b und 3 b** gezeigt, wächst die erfindungsgemäße Schicht in der ersten Stufe zunächst pyramidenförmig in die Höhe (1), wodurch die Tiefe der Rauhigkeiten eingestellt werden kann (hier Rₘₐₓ bezeichnet) und in der zweiten Stufe flächenmäßig (2) in die Breite, wodurch das Oberflächenverhältnis als Verhältnis der Flächenanteile A2 zu A1 eingestellt werden kann. Hierbei bedeutet der Flächenanteil A2 die Ausdehnung der pyramidenförmig in der 1. Stufe gewachsenen Kristallite parallel zur Substratoberfläche und der Flächenanteil A1 die Öffnungsweite der Vertiefungen. Das Höhenwachstum ist in der zweiten Stufe zwar nicht vollkommen unterdrückt, jedoch überwiegt das Flächenwachstum bei weitem.

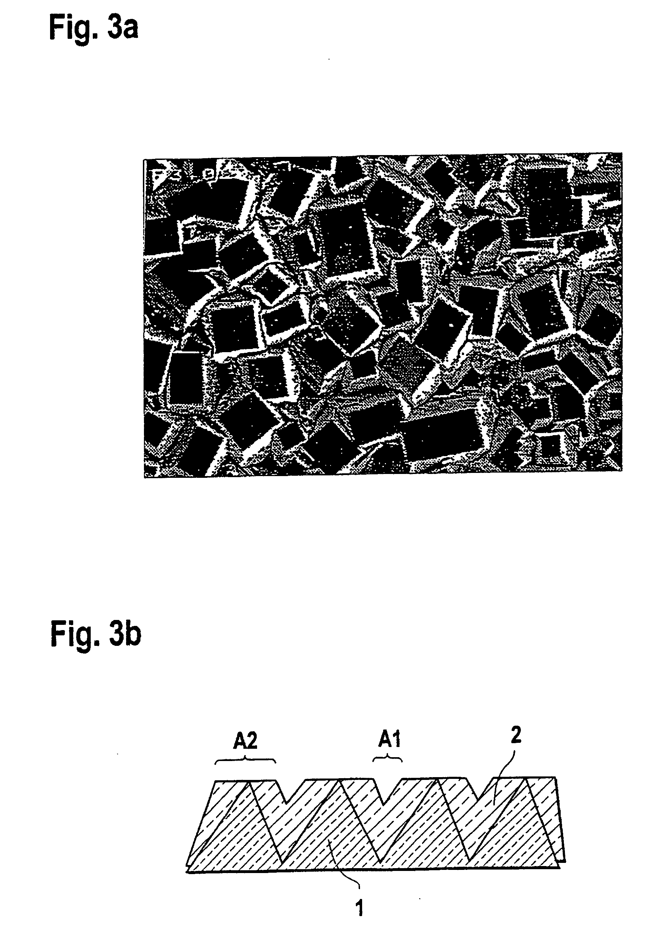

Durch das Ausmaß des Flächenwachstums, das auch in den Vertiefungen erfolgt, wie in Figur 3b angezeigt, und mit zunehmenden Wachstum die Tiefe verringert, kann die Oberflächenrauhigkeit je nach Bedarf eingestellt werden.

Die Tiefe der Rauhigkeiten Rₘₐₓ sowie das Oberflächenverhältnis A2 : A1 unterliegt keinen speziellen Beschränkungen und kann je nach Bedarf frei variiert werden.

Das gezielte Aufwachsenlassen von (100)-orientierten Diamantfilmen unter geeigneter Variation der Abscheidungsparameter mittels plasmaunterstützten Mikrowellen CVD ist beispielsweise in C. Wild et al. "Chemical vapour deposition and characterization of smooth (100)-faceted diamond films" in: Diamond and Related Materials 2 (1993), Seiten 158 bis 168, beschrieben und diskutiert.

Ein besonders bevorzugtes Verfahren zur Herstellung der erfindungsgemäßen Schichten mit definierter Oberflächenrauhigkeit ist das hot filament chemical vapor deposition-Verfahren (HF-CVD-Verfahren), wie es beispielsweise von Bachmann und van Enckeford, "Diamond deposition technologies", in: Diamant and Related Material 1 (1992), Seiten 1021 bis 1034, diskutiert und beschrieben worden ist.

Es versteht sich jedoch und ist Fachleuten allgemein bekannt, dass für Schichtabscheidungsverfahren die Verfahrensparameter untereinander und in Abhängigkeit der jeweils verwendeten konkreten Appratur aufeinander abzustimmen sind.

Für das selektive Aufwachsenlassen der erfindungsgemäßen Diamantschicht in (100)-Orientierung ist es vorteilhaft, dem Reaktionsgas der ersten Stufe eine geringfügige Menge an Stickstoff zuzusetzen.

Zudem hat es sich als vorteilhaft erwiesen, die Konzentration der Kohlenstoffverbindung in der ersten Stufe höher zu wählen als in der zweiten Stufe.

Die Filament- und Substrattemperatur sollte in der zweiten Stufe höher sein als in der ersten Stufe.

Im folgenden wird das erfindungsgemäß bevorzugte HF-CVD-Verfahren zur Herstellung der erfindungsgemäßen Diamantschicht anhand eines Beispiels erläutert.

Ein geeigneter Reaktor für dieses Beispiel kann ein Volumen von 0,12 m³, Tantalfilamente mit einem Durchmesser von 1 mm und einen Filament-Substratabstand von 10 mm aufweisen.

Für die erste Stufe wird ein Gasgemisch aus 1,2 bis 2,6 Vol% Methan als Kohlenstoffverbindung, 10 bis 100 ppm Stickstoff und Rest Wasserstoff verwendet. Die Filamenttemperatur beträgt vorzugsweise 2300 bis 2500 °C bei einer Substrattemperatur von 800 bis 850 °C. Die Abscheidungsdauer richtet sich nach der gewünschten Rauhigkeitstiefe.

Für die zweite Stufe beträgt die Zusammensetzung des Gasgemisches vorzugsweise 0,6 bis 1,6 Vol% Methan als Kohlenstoffverbindung und Rest Wasserstoff. Die Filamenttemperatur sollte bei etwa 2400 bis 2600 °C bei einer Substrattemperatur von etwa 875 bis 950 °C liegen. Die Abscheidungsdauer richtet sich nach dem gewünschten Oberflächenverhältnis.

Ein geeigneter Druck für beide Stufen liegt bei etwa 40 mbar bei einem Gasfluss von etwa 1 sim (Standardliter pro Minute).

Das erfindungsgemäße Verfahren eignet sich insbesondere auch zur Beschichtung von großflächigen und/oder kompliziert aufgebauten Substraten.

Die auf der erfindungsgemäßen Diamantschicht erzeugten Rauhigkeiten dienen zur Aufnahme von wenigstens einem zusätzlichen Material, das der Oberfläche die gewünschte zusätzliche Eigenschaft verleiht und somit als Funktionsschicht bezeichnet werden kann.

Beispielsweise kann die Reibung und der Gegenkörperverschleiß durch Materialien wie festen oder flüssigen Schmierstoffen, Sulfiden, Seleniden, Teflon, weichen Metallen, zum Beispiel Zinn, Aluminium oder Blei, sowie durch Auftragen von DLC-Schichten minimiert werden. Die Oberflächenenergie beziehungsweise Benetzbarkeit kann zum Beispiel durch Silicon, Sulfide, Teflon oder DCL-Schichten variiert werden.

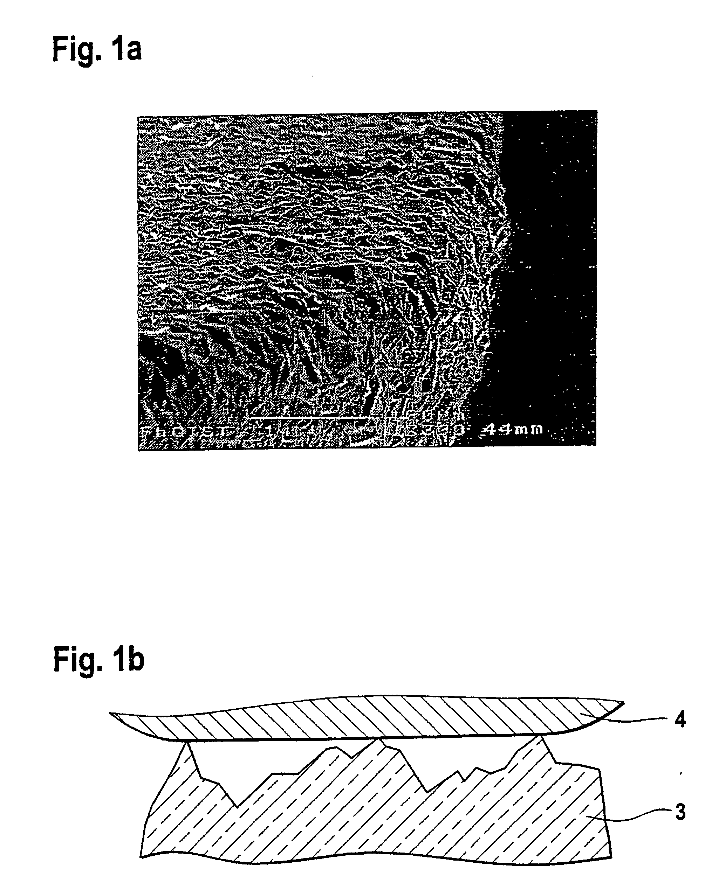

Zudem hat sich gezeigt, dass die hydrodynamische Tragfähigkeit von Komponenten, die mit der erfindungsgemäßen Diamantschicht mit definiert einstellbarer Oberflächenrauhigkeit beschichtet sind, erheblich verbessert ist. Dieser Effekt wird auf die vergleichsweise regelmäßige und gleichförmige Ausbildung der Unebenheiten, d. h. Vertiefungen, zurückgeführt. Anders als bei statistisch-orientiert gewachsenen Schichten, bei denen ein Gegenkörper nur auf wenigen Spitzen läuft, wie in Fig. 1 b schematisch dargestellt, liegt bei der erfindungsgemäßen Diamantschicht ein Gegenkörper durchgängig auf einer vergleichsweise ebenen Fläche auf, wie sie in Fig. 3 b dargestellt ist. Vorzugsweise beträgt der Anteil an Vertiefungen (A1) in diesem Fall 30 bis 90 %, insbesondere 50 bis 60 %, der Gesamtoberfläche.

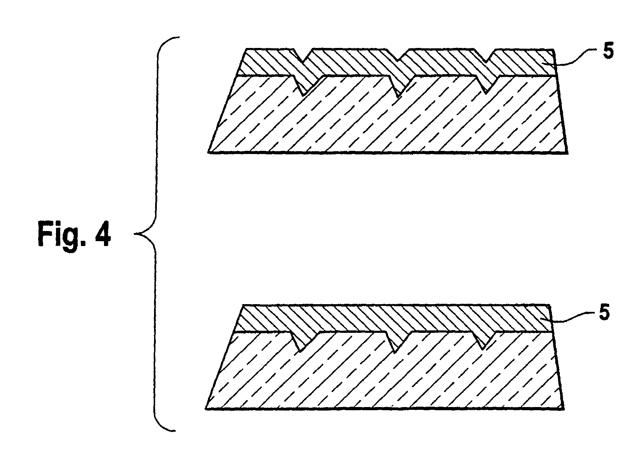

Beispiele für Aufbringungsmöglichkeiten des zusätzlichen Materials (5) sind in Figur 4 gezeigt

In der folgenden Liste sind Beispiele für Anwendungsmöglichkeiten der erfindungsgemäßen Diamantschicht mit zusätzlichem Material sowie geeignete Materialien zur Beeinflussung bestimmter Oberflächeneigenschaften genannt:
- Zerspanwerkzeuge, wie Wendeschneidplatten, Fräser, Bohrer:
   Verringerung der Reibung, der Kiebneigung, verbesserter Spanablauf, insbesondere bei Leichtmetallen durch Schichten aus amorphem Kohlenstoff und/oder MoS₂;
- Presswerkzeuge, wie Presswerkzeuge für Sinterbauteile (z. B. Keramik und Hartmetallteile), Tablettenstempel:
   Verringerung von Kleben durch amorphen Kohlenstoff und/oder Teflon, Erzielung einer Antihaftwirkung, insbesondere für Tablettenstempel mit einem bevorzugten Flächenanteil der Antihaftfläche von 80 bis 90 % der Gesamtoberfläche und Rest Diamant;
- Umformwerkzeuge, wie Tiefziehwerkzeuge:
   Nutzung der Vertiefungen zur Verbesserung der hydrodynamischen Tragfähigkeit (bevorzugter Oberflächenanteil der Vertiefungen 30 bis 60 % der Gesamtober-fläche), Erzielung einer Antihaftwirkung, insbesondere bei Leichtmetallbearbeitung durch amorphen Kohlenstoff und/Teflon;
- Lager, wie Gleit- und Kugellager:
   Verringerung der Reibung und des Gegenkörperverschleißes durch Teflon MoS₂ und/oder weichen Metallen, insbesondere bei Gleitlagern, Ausnutzung der Vertiefungen zur Verbesserung der hydrodynamischen Tragfähigkeit (bevorzugter Oberflächenanteil der Vertiefungen 30 bis 60% der Gesamtoberfläche);
- Kolben/Zylinderpaarungen, wie bei Pumpen, zum Beispiel Chemiepumpen:
   Nutzung der Vertiefungen zur Verbes-serung der hydrodynamischen Trag-fähigkeit, Verringerung der Reibung durch Teflon und/oder MoS₂; und
- Führungselemente, wie Linearführungen und Fadenführer:
   Verringerung der Verschmutzungsgefahr durch Teflon und/oder amorphen Kohlenstoff, Verringerung der Reibung durch zum Beispiel MoS_{2.}

Bei der Funktionsschicht kann es sich um ein gefärbtes Material handeln, um zum Beispiel die jeweilige beschichtete Komponente mit einer gewünschten Farbe zu versehen oder es kann ein Lack sein.

Das Aufbringen der Materialien und das Füllen der Rauhigkeitstäler kann mit beliebigen hierfür geeigneten Verfahren erfolgen und unterliegt im allgemeinen keinen besonderen Beschränkungen. Beispiele für geeignete Verfahren sind zum Beispiel Tauchen, einfaches Auftragen, Beschichten, etc.

Das zusätzliche Material kann auch in einem PVD oder CVD-Verfahren aufgebracht werden. Insbesondere kann hierbei die Aufbringung "in situ" erfolgen, dass heißt, in der gleichen Beschichtungsanlage wie die Diamantschichtabscheidung in Anschluss an die Diamantschichtabscheidung.

Es versteht sich, dass die vorliegende Erfindung eine Vielzahl von Möglichkeiten bietet, die Oberflächeneigenschaften von Diamantschichten auf Werkzeugen und Bauteilen je nach Bedarf und Verwendungszweck zu variieren.

### Bezugszeichenliste

- 1): Wachstum in der 1. Stufe
- 2): Wachstum in der 2. Stufe
- 3): statistisch-orientiert gewachsene Diamantschicht
- 4): Gegenkörper
- 5): zusätzliches Material

## Patentansprüche

1. Polykristalline Diamantschicht mit (100)-Textur und definiert eingestellter Oberflächenrauhigkeit, die auf einem Substrat aufgebracht ist,
**dadurch gekennzeichnet,**
**dass** die definiert eingestellte Oberflächenrauhigkeit durch Vorsehen von Vertiefungen in dieser Schicht erhalten wird mit definiert eingestellter Tiefe und eingestelltem Flächenanteil der Öffnungsweiten A1 der Vertiefungen, und zumindest in einem Teil der Vertiefungen mindestens ein zusätzliches Material zur Verbesserung der Eigenschaften der Diamantschicht aufgebracht ist.

2. Polykristalline Diamantschicht nach Anspruch 1,
**dadurch gekennzeichnet,**
**dass** der Flächenanteil der Öffnungsweite A1 30-90 % der Gesamtoberfläche beträgt.

3. Polykristalline Diamantschicht nach Anspruch 1 oder 2,
**dadurch gekennzeichnet,**
**dass** das Material ausgewählt ist unter Materialien zur Verbesserung des tribologischen Verhaltens.

4. Polykristalline Diamantschicht nach einem der Ansprüche 1 bis 3,
**dadurch gekennzeichnet,**
**dass** das Material ein Material zur Verringerung der Reibung, zur Verringerung der Klebneigung, zur Verringerung der Verschmutzung, ein Material mit Antihaftwirkung oder ein Material zur Optimierung der Benetzbarkeit ist.

5. Polykristalline Diamantschicht nach einem der Ansprüche 1 bis 4,
**dadurch gekennzeichnet,**
**dass** das Material ausgewählt ist unter einem festen oder flüssigen Schmierstoff, einem Sulfid, einem Selenid, Teflon, Zinn, Aluminium, Blei, DLC-Schichten und Silicon.

6. Verfahren zur Herstellung einer polykristallinen Diamantschicht mit (100)-Textur und definiert eingestellter Oberflächenrauhigkeit nach einem der Ansprüche 1 bis 5,
**dadurch gekennzeichnet,**
**dass** in einem Gasabscheidungsverfahren auf einem Substrat Diamantkristalle in (100)-Orientierung aufwachsen gelassen werden, wobei in einer ersten Stufe die Vorzugsrichtung des Kristallwachstums senkrecht zur Substratoberfläche und in einer zweiten Stufe die Vorzugsrichtung des Kristallwachstums waagerecht zur Substratoberfläche gewählt und die Oberflächenrauhigkeit durch das Ausmaß des Kristallwachstums in der 2. Stufe eingestellt wird, und in die durch Einstellung der Oberflächenrauhigkeit erhaltenen Vertiefungen mindestens ein zusätzliches Material zur Verbesserung der Eigenschaften der Diamantschicht eingebracht wird.

7. Verfahren zur Herstellung einer polykristallinen Diamantschicht nach Anspruch 6,
**dadurch gekennzeichnet,**
**dass** die Abscheidung mit einem hot filament chemical vapour deposition-Verfahren durchgeführt wird.

8. Verfahren nach Anspruch 6 oder 7,
**dadurch gekennzeichnet,**
**dass** dem Reaktionsgasgemisch in der ersten Stufe Stickstoff zugesetzt wird.

9. Verfahren nach einem der Ansprüche 6 bis 8,
**dadurch gekennzeichnet,**
**dass** die Konzentration der Kohlenstoffverbindung in dem Reaktionsgasgemisch in der ersten Stufe höher gewählt wird als in der zweiten Stufe.

10. Verfahren nach einem der Ansprüche 6 bis 9,
**dadurch gekennzeichnet,**
**dass** die Filamenttemperatur und die Substrattemperatur in der zweiten Stufe höher gewählt werden als in der ersten Stufe.

11. Werkzeug oder Bauteil, das zumindest teilweise mit einer polykristallinen Diamantschicht nach einem der Ansprüche 1 bis 5 beschichtet ist.

12. Werkzeug nach Anspruch 11,
**dadurch gekennzeichnet,**
**dass** das Werkzeug ein Zerspanwerkzeug, ein Presswerkzeug oder ein Umformwerkzeug ist.

13. Bauteil nach Anspruch 11,
**dadurch gekennzeichnet,**
**dass** das Bauteil ein Lager, eine Kolben/Zylinder-Paarung oder ein Führungselement ist.

## Claims

1. Polycrystalline diamond layer with (100)-facetted texture and selectively adjusted surface roughness, which is applied to a substrate, **characterised in that** the selectively adjusted surface roughness is obtained by the provision of depressions in this layer and with selectively adjusted depth and adjusted surface proportion of the widths A1 of the openings of the depressions and at least in some of the depressions at least one additional material is applied to improve the properties of the diamond layer.

2. Polycrystalline diamond layer according to Claim 1, **characterised in that** the surface proportion of the opening width A1 amounts to 30-90% of the total surface.

3. Polycrystalline diamond layer according to Claim 1 or 2, **characterised in that** the material is selected from materials for improving the tribological behaviour.

4. Polycrystalline diamond layer according to one of Claims 1 to 3, **characterised in that** the material is a material for reducing friction, for reducing adhesion tendency, for reducing contamination, a material with anti-adhesive effect or a material for optimising wettability.

5. Polycrystalline diamond layer according to one of Claims 1 to 4, **characterised in that** the material is selected from a solid or liquid lubricant, a sulphide, a selenide, Teflon, tin, aluminium, lead, DLC layers and silicon.

6. Process for the production of a polycrystalline diamond layer with (100)-facetted texture and selectively adjusted surface roughness according to one of Claims 1 to 5, **characterised in that** diamond crystals are allowed to grow with (100)-facetted orientation on a substrate in a gas deposition process, wherein in a first stage the preferred direction of the crystal growth selected is vertical to the substrate surface and in a second stage the preferred direction of the crystal growth selected is horizontal to the substrate surface and the surface roughness is adjusted by the extent of crystal growth in the second stage, and at least one additional material for improvement of the properties of the diamond layer is introduced into the depressions obtained by adjusting the surface roughness.

7. Process for the production of a polycrystalline diamond layer according to Claim 6, **characterised in that** the deposition is performed using a hot filament chemical vapour deposition process.

8. Process according to Claim 6 or 7, **characterised in that** nitrogen is added to the reaction gas mixture in the first stage.

9. Process according to one of Claims 6 to 8, **characterised in that** the concentration of the carbon compound in the reaction gas mixture selected is higher in the first stage than in the second stage.

10. Process according to one of Claims 6 to 9, **characterised in that** the filament temperature and the substrate temperature selected is higher in the second stage than in the first stage.

11. Tool or component, which is coated at least partially with a polycrystalline diamond layer according to one of Claims 1 to 5.

12. Tool according to Claim 11, **characterised in that** the tool is a cutting tool, a pressing tool or a forming tool.

13. Component according to Claim 11, **characterised in that** the component is a bearing, a piston/cylinder combination or a guide element.

## Revendications

1. Couche de diamant polycristalline dotée d'une texture (100) et d'une rugosité superficielle définie, qui est déposée sur un substrat,
**caractérisée en ce que**
la rugosité superficielle définie est obtenue par la réalisation de creux dans cette couche, avec une profondeur et une proportion surfacique définies de l'ouverture A1 des creux, et qu'au moins dans une partie des creux, au moins un matériau supplémentaire est appliqué pour l'amélioration des propriétés de la couche de diamant.

2. Couche de diamant polycristalline selon la revendication 1,
**caractérisée en ce que**
la proportion surfacique de l'ouverture A1 représente 30 à 90% de la surface totale.

3. Couche de diamant polycristalline selon la revendication 1 ou 2,
**caractérisée en ce que**
le matériau est choisi parmi des matériaux pour l'amélioration du comportement tribologique.

4. Couche de diamant polycristalline selon l'une des revendications 1 à 3,
**caractérisée en ce que**
le matériau est un matériau pour réduire le frottement, pour réduire la tendance à l'adhérence, pour réduire l'encrassement, un matériau doté d'un effet anti-adhérent ou un matériau pour l'optimisation de la mouillabilité.

5. Couche de diamant polycristalline selon l'une des revendications 1 à 4,
**caractérisée en ce que**
le matériau est choisi parmi un lubrifiant solide ou liquide, un sulfure, un séléniure, du Téflon, de l'étain, de l'aluminium, du plomb, des couches DLC et du silicone.

6. Procédé pour la fabrication d'une couche de diamant polycristalline dotée d'une texture (100) et d'une rugosité superficielle définie, selon l'une des revendications 1 à 5,
**caractérisé en ce que**
dans un procédé par séparation gazeuse, des cristaux de diamant sont laissés à croître dans une orientation (100) sur un substrat, le sens préférentiel de croissance des cristaux étant choisi dans une première étape perpendiculaire à la surface du substrat et dans une seconde étape parallèle à la surface du substrat et la rugosité superficielle étant déterminée par la quantité de croissance des cristaux dans la seconde étape, au moins un matériau supplémentaire pour l'amélioration des propriétés de la couche de diamant étant déposé dans les creux obtenus par la définition de la rugosité superficielle.

7. Procédé pour la fabrication d'une couche de diamant polycristalline selon la revendication 6,
**caractérisé en ce que**
la séparation est réalisée avec un procédé de "hot filament chemical vapour deposition".

8. Procédé selon la revendication 6 ou 7,
**caractérisé en ce que**
de l'azote est ajouté dans le mélange réactionnel gazeux dans la première étape.

9. Procédé selon l'une des revendications 6 à 8,
**caractérisé en ce que**
la concentration de la liaison carbone dans le mélange réactionnel gazeux est choisie supérieure dans la première étape que dans la seconde étape.

10. Procédé selon l'une des revendications 6 à 9,
**caractérisé en ce que**
la température du filament et la température du substrat sont choisies supérieures dans la première étape que dans la seconde étape.

11. Outil ou élément de construction qui est recouvert au moins partiellement par une couche de diamant polycristalline selon l'une des revendications 1 à 5.

12. Outil selon la revendication 11,
**caractérisé en ce que**
l'outil est un outil de coupe, un outil de compression ou un outil de formage.

13. Outil selon la revendication 11,
**caractérisé en ce que**
l'élément de construction est un palier, un couple piston/cylindre ou un élément de guidage.
